**Europäisches Patentamt**

**European Patent Office**

**Office européen des brevets**

(11) Veröffentlichungsnummer: **0 217 200**
**A1**

## (12) EUROPÄISCHE PATENTANMELDUNG

(21) Anmeldenummer: **86112635.7**

(22) Anmeldetag: **12.09.86**

(51) Int. Cl.⁴: **H 03 F 3/217**

(30) Priorität: **28.09.85 DE 3534678**

(43) Veröffentlichungstag der Anmeldung:
**08.04.87 Patentblatt 87/15**

(84) Benannte Vertragsstaaten:
**CH DE FR GB LI**

(71) Anmelder: **Licentia Patent-Verwaltungs-GmbH**
**Theodor-Stern-Kai 1**
**D-6000 Frankfurt/Main 70(DE)**

(72) Erfinder: **Lodahl, Manfred, Dipl.-Ing.**
**Spindelmühlerweg 6**
**D-1000 Berlin 45(DE)**

(74) Vertreter: **Schulze, Harald Rudolf, Dipl.-Ing. et al,**
**Licentia Patent-Verwaltungs-GmbH Theodor-Stern-Kai 1**
**D-6000 Frankfurt/Main 70(DE)**

(54) Schaltverstärker.

(57) Ein Schaltverstärker, insbesondere zur Erzeugung einer modulierten Anodenspannung bei einem amplitudenmodulierten Hochfrequenz-Hochleistungssender. Dabei wird eine Hintereinanderschaltung von schaltbaren Teilspannungsquellen in zwei Reihenschaltungen ($R_1$, $R_2$) aufgeteilt, von denen eine ($R_1$) als Folgeschaltung ausgebildet ist und lediglich grobe Spannungssprünge erzeugt, während die andere ($R_2$) die erforderliche Feinstufung bewirkt durch in beliebiger Reihenfolge schaltbare Teilspannungsquellen.

FIG. 1

0217200

Licentia Patent-Verwaltungs-GmbH          PTL-UL/Ja/rß
Theodor-Stern-Kai 1                       UL 85/68
D-6000 Frankfurt 70
                                          Aktz.:
                                          P 35 34 678.7

**Beschreibung**

Schaltverstärker

Die Erfindung betrifft einen Schaltverstärker nach dem
Oberbegriff des Patentanspruchs 1.

Die Erfindung ist insbesondere anwendbar für die Erzeugung
einer NF(Niederfrequenz)-modulierten Anodenspannung eines
amplitudenmodulierten Hochfrequenz-Hochleistungssenders,
der beispielsweise eine Ausgangsleistung von ungefähr
600kW hat.

Aus der DE-OS 18 16 530 ist ein analog arbeitender Leistungsverstärker bekannt, bei dem eine Ausgangsspannung in
Abhängigkeit von einem gleich großen analogen Steuersignal
gesteuert wird. Dabei sind mehrere Teilspannungsquellen
derart hintereinander geschaltet, daß jedem Spannungsbereich eine bestimmte Teilspannungsquelle zugeordnet ist.

...

Für eine gute Linearität des Ausgangssignales ist es erforderlich, entweder sehr viele Teilspannungsquellen zu verwenden, die dann lediglich ein- oder ausgeschaltet werden, oder wenige Teilspannungsquellen zu verwenden, deren jeweilige Ausgangsspannung in einem bestimmten Bereich analog gesteuert wird. Als steuernde Bauelemente sind gittergesteuerte Röhren und/oder Transistoren geeignet.

Eine derartige Anordnung ist in nachteiliger Weise lediglich als Wechselspannungsverstärker kleiner Leistung geeignet, z.B. für einen Frequenzbereich von 40Hz bis 4 kHz. Weiterhin ist keine kostengünstige Feinstufung der Ausgangsspannung möglich, z.B. binär oder durch eine Puls-Dauer-Modulation, da die Teilspannungsquellen immer der Reihe nach ein- oder ausgeschaltet werden, entsprechend der Größe des in nachteiliger Weise gleich großen Steuersignals.

Aus der DE-OS 30 44 956 sowie der europäischen Patentanmeldung 00 66 904 A1 sind Schaltverstärker bekannt, bei denen die erwähnten Nachteile vermieden werden. Bei diesen Schaltverstärkern ensteht jedoch in nachteiliger Weise eine kapazitive Belastung der Ausgangsspannung, welche von den Trafowicklungen der Teilspannungsquellen herrührt.

Der Erfindung liegt daher die Aufgabe zugrunde, einen gattungsgemäßen Schaltverstärker dahingehend zu verbessern, daß in kostengünstiger Weise ein hoher Wirkungsgrad bei guter Linearität des Ausgangssignals möglich ist und daß die Teilspannungsquellen in zuverlässiger Weise lediglich mit Halbleiterbauelementen schaltbar sind.

...

0217200

- 3 -

UL 85/68

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß die Teilspannungsquellen lediglich ein- oder ausgeschaltet werden, so daß eine Ansteuerung mit digitalen Steuersignalen möglich ist.

Ein zweiter Vorteil besteht darin, daß der Spannungswert einer Vielzahl von Teilspannungsquellen nicht nach dem Gesichtspunkt der optimalen Linearität festgelegt ist, sondern nach Maßgabe der für Halbleiterschalter maximal zulässigen Spannung. Es ist trotzdem eine Feinstufung der Ausgangsspannung vorhanden, so daß eine gute Linearität erreichbar ist.

Die Erfindung wird im folgenden anhand eines Ausführungsbeispiels näher erläutert unter Bezugnahme auf eine schematische Zeichnung. Es zeigen

FIG. 1     ein schematisches Schaltbild des Ausführungsbeispiels

FIG. 2     Ausführungsbeispiele von Schaltblöcken in Fig. 1. bis 4

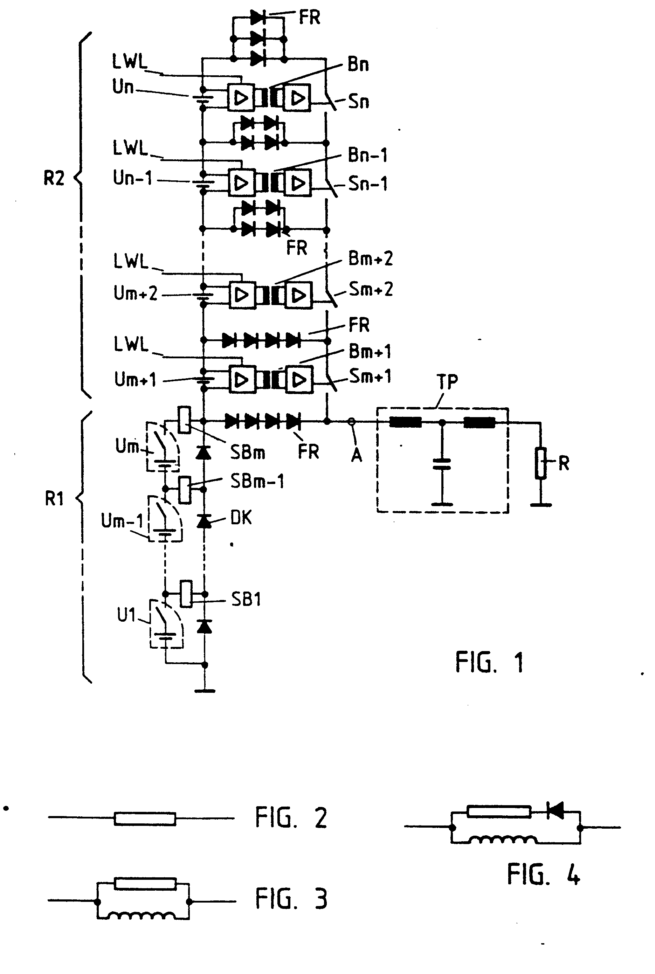

Fig. 1 zeigt lediglich ein Ausführungsbeispiel des Leistungsteils des Schaltverstärkers. Denn die dafür erforderliche Steuerschaltung, in der z.B. die Aufbereitung des zu verstärkenden NF-Signales enthalten ist, ergibt sich

...

für einen Fachmann aus der Beschreibung der Funktionsweise des Schaltverstärkers. Die hintereinander schaltbaren Teilspannungsquellen U1 bis Un sind in eine erste Reihenschaltung R1 sowie eine zweite Reihenschaltung R2 aufgeteilt. Am Ausgang A ensteht ein Ausgangssignal mit einer maximalen Amplitude von z.B. 30 kV bei einem Strom von ungefähr 100 A. Dieses Ausgangssignal wird in einem nachgeschalteten Tiefpaßfilter TP geglättet und einer Last R zugeführt, z.B. der Anode der Endstufenröhre eines Hochfrequenz-Hochleistungssenders. Die zweite Reihenschaltung R2 enthält z.B. fünfzig hintereinander schaltbare Teilspannungsquellen Um+1 bis Un, die jeweils im wesentlichen gleiche Gleichspannungen von jeweils ungefähr 600 V erzeugen. Diese Teilspannungsquellen Um+1 bis Un sind lediglich nacheinander zu- oder abschaltbar durch eine Reihenschaltung von Schaltern Sm+1 bis Sn, die z.B. als Halbleiterschalter mit einer zulässigen Sperrspannung von ungefähr 1,2 kV ausgebildet sind. Zwischen jeder Teilspannungsquelle und dem zugehörigen Schalter sind Verbindungsleitungen vorhanden, in denen in Reihe- und/oder parallelgeschaltete Halbleiterdioden vorhanden sind, die als Freilaufdioden FR wirken. Die Schalter Sm+1 bis Sn sind durch zugehörige Betätigungsschaltungen Bm+1 bis Bn schaltbar. Diese werden z.B. einzeln mit elektrischer Energie versorgt durch die zugehörigen Teilspannungsquellen, enthalten die erforderlichen Schaltverstärker sowie die erforderlichen Schaltungen, z.B. Übertrager, zur Potentialtrennung. Die Betätigungsschaltungen Bm+1 bis Bn werden z.B. durch Lichtimpulse über Lichtwellenleiter LWL angesteuert (getriggert). Die Funktionsweise dieser

...

zweiten Reihenschaltung R2 entspricht im wesentlichen derjenigen aus der eingangs erwähnten DE-OS 18 16 530 jedoch mit dem Unterschied, daß lediglich digitale Steuersignale erforderlich sind.

An die zweite Reihenschaltung R2 ist die erste Reihenschaltung R1 der schaltbaren Teilspannungsquellen U1 bis Um angeschlossen derart, daß ein Anschluß der ersten Reihenschaltung R1 vorzugsweise auf Masse(Erd)-Potential liegt, sofern ein Anschluß der Last R ebenfalls auf Masse-Potential liegt. In der ersten Reihenschaltung R1 dienen die Teilspannungsquellen U1 bis Um zur Feinstufung der Ausgangsspannung und erzeugen daher Ausgangsspannungen, die z.B. binär gewichtet und unabhängig voneinander addierbar sind. Dieses wird über eine Diodenkaskade DK möglich, die parallel geschaltet ist zu den hintereinander geschalteten schaltbaren Teilspannungsquellen U1 bis Um. In die Verbindungsleitungen zwischen den Teilspannungsquellen und den zugehörigen Dioden der Diodenkaskade DK sind Strombegrenzer SB1 bis SBm eingefügt. Diese begrenzen die beim Schalten entstehenden Spitzenströme, insbesondere sogenannte Kommutierungsströme, und ermöglichen daher vorteilhafterweise eine wesentlich höhere Belastung der Teilspannungsquellen U1 bis Um. Die Anzahl der Teilspannungsquellen U1 bis Um sowie die jeweils erzeugten Ausgangsspannungen sind abhängig von der gewünschten Linearität der Ausgangsspannung. Beispielsweise erzeugt die Teilspannungsquellen U1 eine Minimalspannung von ungefähr 10 V während die Teilspannungsquelle Um eine Maximalspannung von 320 V erzeugt. Die übrigen Teilspannungsquellen erzeugen binär gewichtete Zwischenwerte.

Die Fig. 2 bis 4 zeigen Ausführungsbeispiele von Strombegrenzern SB1 bis SBm. Diese bestehen z.B. aus einem ohmschen Widerstand (Fig. 2), einer Parallelschaltung eines ohmschen Widerstandes mit einer Spule (Fig. 3) und/oder einer Parallelschaltung einer Spule mit einer Reihenschaltung aus einem ohmschen Widerstand sowie einer Diode (Fig. 4).

Die Erfindung ist nicht auf das beschriebene Ausführungsbeispiel beschränkt, sondern sinngemäß auf weitere anwendbar. Beispielsweise ist es möglich, die dargestellten Halbleiterschalter als Reihen- und/oder Parallelschaltung von Halbleiterbauelementen auszubilden, die speziell für Ein- oder Ausschaltvorgänge hergestellt sind.

Licentia Patent-Verwaltungs-GmbH          PTL-UL/Ja/rß
Theodor-Stern-Kai 1                        UL 85/68
D-6000 Frankfurt 70

Patentansprüche

1. Schaltverstärker, bestehend aus schaltbaren Teilspannungsquellen, die in Abhängigkeit von einem zu verstärkenden NF-Signal geschaltet werden und die zu einer Hintereinanderschaltung zusammengeschaltet sind, die ein dem verstärkten NF-Signal entsprechendes Ausgangssignal erzeugt, insbesonder zur Erzeugung einer modulierten Anodenspannung für einen amplitudenmodulierten Hochfrequenz-Hochleistungssender, dadurch gekennzeichnet,

- daß in der Hintereinanderschaltung eine erste Reihenschaltung (R1) von schaltbaren Teilspannungsquellen und eine zweite Reihenschaltung (R2) von schaltbaren Teilspannungsquellen hintereinander geschaltet sind,
- daß die erste Reihenschaltung (R1) eine Prallelschaltung hintereinandergeschalteter schaltbarer Teilspannungsquellen (U1 bis Um) mit einer Diodenkaskade (DK) enthält, wobei jeder Teilspannungsquelle eine Diode der Diodenkaskade parallel geschaltet ist über Ver-

...

bindungsleitungen, in denen mindestens ein Strombegrenzer (SB1 bis SBm) vorhanden ist, und

- daß die zweite Reihenschaltung (R2) eine Parallelschaltung hintereinandergeschalteter Teilspannungsquellen (Um+1 bis Un) mit hintereinander geschalteten Schaltern (Sm+1 bis Sn) enthält, wobei jeder Teilspannungsquelle ein Schalter parallel geschaltet ist über Verbindungsleitungsleitungen, die jeweils mindestens eine Freilaufdiode (FR) enthalten.

2. Schaltverstärker nach Anspruch 1, dadurch gekennzeichnet, daß ein Ende der ersten Reihenschaltung (R1) sowie eine Ende der zu betreibenden Last (R) auf dem gleichen Potential liegen, vorzugsweise auf Masse-Potential.

3. Schaltverstärkerh Anspruch 1 oder Anspruch 2, dadurch gekennzeichnet, daß mindestens ein Strombegrenzer (SB1 bis SBm) als Widerstand oder als Parallelschaltung eines Widerstandes mit einer Spule oder als Parallelschaltung einer Spule mit einer Reihenschaltung von einem Widerstand und einer Diode ausgebildet ist (Fig. 2 bis 4).

4. Schaltverstärker nach einem der vorhergehenden Ansprüche, dadurch gekennzeichnet, daß die in der ersten Reihenschaltung (R1) erzeugbare maximale Spannung im wesentlichen gleich ist der Spannung einer der Teilspannungsquellen der zweiten Reihenschaltung (R2).

5. Schaltverstärker nach einem der vorhergehenden Ansprüche, dadurch gekennzeichnet, daß in der zweiten Reihenschaltung (R2) jeder der Schalter (Sm+1 bis Sn) an eine Betätigungsschaltung (Bm+1 bis Bn) angeschlossen ist, die eine Potentialtrennung ermöglicht.

...

6. Schaltverstärker nach einem der vorhergehenden Ansprüche, dadurch gekennzeichnet, daß in der ersten Reihenschaltung (R1) die Teilspannungsquellen in beliebiger Reihenfolge schaltbar sind und daß in der zweiten Reihenschaltung (R2) die Teilspannungsquellen in einer Folgeschaltung schaltbar sind.

7. Schaltverstärker nach einem der vorhergehenden Ansprüche, dadurch gekennzeichnet, daß der Ausgang (A) über ein Tiefpaßfilter (TP) mit einer Last (R) verbunden ist, die als amplitudenmodulierte Endstufenröhre eines Hochfrequenz-Hochleistungssenders ausgebildet ist.

...

0217200

FIG. 1

FIG. 2

FIG. 3

FIG. 4

Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | EP-A-0 083 727 (HARRIS CORP.)<br><br>* Figuren 1-4,9; Seite 15, Zeile 23 - Seite 20, Zeile 13; Seite 33, Zeile 17 - Seite 35, Zeile 3 *<br><br>--- | 1,2,4,6 | H 03 F 3/217 |
| A | GB-A-2 064 901 (HARRIS CORP.)<br>* Figuren 1-3; Seite 4, Zeile 104 - Seite 5, Zeile 79 * & DE-A-3 044 956 (Kat. D,A)<br><br>--- | 1,7 | |
| A | EP-A-0 025 234 (PATELHOLD)<br>* Figur 1; Zusammenfassung *<br><br>----- | 1 | |

| RECHERCHIERTE SACHGEBIETE (Int. Cl 4) |
|---|
| H 03 F |

Der vorliegende Recherchenbericht wurde für alle Patentansprüche erstellt

| Recherchenort | Abschlußdatum der Recherche | Prüfer |
|---|---|---|
| DEN HAAG | 17-12-1986 | TYBERGHIEN G.M.P. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82